# FASCICULE DE BREVET EUROPEEN

(11) **EP 3 966 851 B1**
(45) Date de publication et mention de la délivrance du brevet: **08.03.2023**
(21) Numéro de dépôt: 20732260.3
(22) Date de dépôt: 24.04.2020
(51) Int. Cl.: H01L 21/48, H01L 23/373, H01L 23/46, H01L 23/498, H01L 25/07, H01L 23/00, H01L 25/00, B33Y 80/00, H01L 23/467, H01L 23/473

(54) **PROCEDE DE FABRICATION D'UN MODULE ELECTRONIQUE DE PUISSANCE**
VERFAHREN ZUR HERSTELLUNG EINES ELEKTRONISCHEN LEISTUNGSMODULS
METHOD FOR MANUFACTURING A POWER ELECTRONIC MODULE

(30) Priorité: 06.05.2019 FR 1904736
(43) Date de publication de la demande: 16.03.2022
(73) Titulaire: SAFRAN, 75015 Paris (FR)
(72) Inventeur: KHAZAKA, Rabih, 77550 MOISSY-CRAMAYEL (FR); FEDI, Baptiste, Joël, Christian, 77550 MOISSY-CRAMAYEL (FR); YOUSSEF, Toni, 77550 MOISSY-CRAMAYEL (FR); SALLOT, Pierre, Jean, 77550 MOISSY-CRAMAYEL (FR)
(74) Mandataire: Ernest Gutmann - Yves Plasseraud S.A.S.
(86) Numéro de dépôt international: PCT/FR2020/050710
(87) Numéro de publication internationale: WO 2020/225500

(56) Documents cités:
- DE-A1-102012 200 325
- FR-A1- 3 060 846
- FR-A1- 3 061 989
- US-A1- 2013 256 894

## Description

### Domaine technique de l'invention

L'invention concerne un procédé de fabrication d'un module électronique de puissance par fabrication additive ainsi qu'un module électronique de puissance obtenu à l'aide d'un tel procédé.

La présente invention trouve une application particulière dans le domaine de l'aéronautique où les contraintes thermiques peuvent être sévères.

### Etat de la technique antérieure

Les modules électroniques de puissance sont utilisés dans des convertisseurs nécessaires pour l'électrification des systèmes propulsifs et non propulsifs à bord des aéronefs afin de convertir l'énergie électrique du réseau principal (115V AC, 230V AC, 540V DC.) sous plusieurs formes (AC/DC, DC/AC, AC/AC et DC/DC).

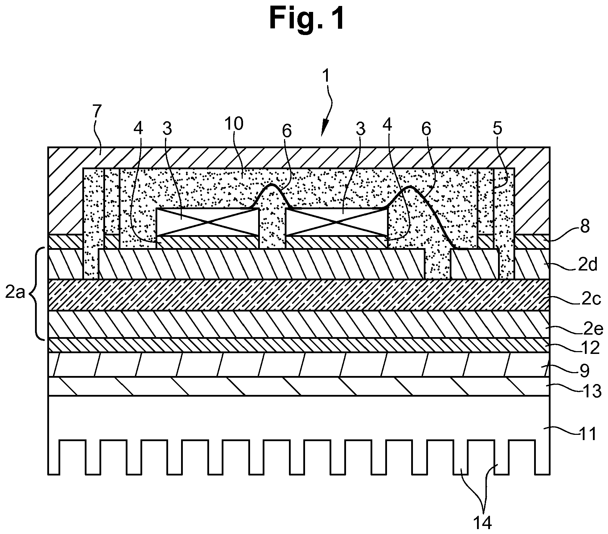

La figure 1 illustre un module électronique de puissance 1 de l'art antérieur. Celui-ci comporte un substrat 2a comportant une couche électriquement isolante 2c en matériau céramique, revêtu sur chacune de ses faces opposées d'une couche métallique 2d, 2e. Un tel ensemble est appelé substrat métallisé 2a.

La couche métallique supérieure 2d forme un circuit de puissance sur lequel des composants à semi-conducteur de puissance 3 sont assemblés. Le module électronique de puissance 1 comprend un joint d'interconnexion électrique et/ou mécanique 4 par l'intermédiaire duquel les composants à semi-conducteur de puissance 3 et des connectiques 5 sont assemblés au circuit de puissance. Du fait de leurs imperfections, les composants à semi-conducteurs de puissance 3 sont le siège de pertes par effet Joules et représentent donc une source importante de chaleur.

Les composants à semi-conducteurs de puissance 3 sont interconnectés électriquement entre eux et avec les connectiques 5 à l'aide des fils de câblage 6. Un boîtier 7, généralement en polymère, est collé à l'aide d'un joint adhésif 8 sur le substrat 2a ou sur une semelle 9 métallique sur laquelle est disposée le substrat 2a. Le boîtier 7 est rempli par un encapsulant 10, tel qu'un gel ou époxy, pour assurer une protection mécanique et électrique des composants de puissance 3 et des fils de câblage 6.

La couche métallique inférieure 2e du substrat 2a est rapportée sur la semelle 9 métallique qui a pour rôle d'étaler le flux thermique et d'assurer une connexion thermique avec un dissipateur thermique 11 métallique. Comme cela est illustré sur la figure 1, le module électronique de puissance 1 comprend un joint d'interconnexion électrique et/ou mécanique 12 par l'intermédiaire duquel la couche métallique 2e inférieure du substrat 2 est rapportée sur la semelle 9.

La semelle 9 est elle-même rapportée sur le dissipateur thermique 11 par l'intermédiaire d'une couche 13 de matériau d'interface thermique, telle qu'une graisse thermique, un film élastomère, ou des matériaux à changement de phase. La couche 13 de matériau d'interface thermique permet de réduire la résistance thermique de contact entre la semelle 9 et le dissipateur thermique 11 pour assurer une meilleure évacuation du flux thermique. Le dissipateur thermique 11, est muni d'ailettes 14 permettant de réduire d'autant plus la résistance thermique de ce dernier, les ailettes 14 étant traversées par un fluide de refroidissement, par exemple de l'air.

Un tel module électronique de puissance 1 est notamment connu du document FR 3 061 989. D'autres modules électroniques de puissance sont également connus des documents US 2013/0020694, US 2016/0073535, US 2016/0126157, US 8 432 030 et US 8 358 000.

Dans certains modules électroniques de puissance (voir notamment les documents US 2013/0020694, US 2016/0126157, US 8 432 030) les composants à semi-conducteurs de puissance sont directement brasés sur de larges surfaces des substrats métallisés. La distance entre les électrodes de commande et de puissance présentes sur lesdits composants est très réduite, de l'ordre de quelques microns, notamment pour les composants à grands gaps (SiC, GaN), rendant ainsi le risque de court-circuit lors du procédé de brasage très élevé. D'autre part, pour les applications à haute température, c'est-à-dire à des températures supérieures à 200°C, les brasures sont généralement réalisées à base de plomb. De telles brasures ne sont pas compatibles avec les directives visant à limiter l'utilisation des substances dangereuses. Il est également connu de réaliser des brasures à base d'or. De telles brasures ont cependant un coût élevé et une fiabilité thermomécanique limitée. Les brasures de type ZnAl souffrent quant à elles d'une faible mouillabilité.

Le document US 8 358 000 divulgue un procédé de fabrication permettant d'assurer une connexion sur des électrodes proches sans risque de court-circuit tout en assurant une isolation entre les connectiques. Un tel procédé reste complexe et coûteux à mettre en oeuvre. Dans le cas des documents US 2013/0020694, US 2016/0073535, US 2016/0126157 et US 8 358 000, l'échangeur thermique est couplé thermiquement au substrat métallisé en utilisant un matériau d'interface thermique. Dans le cas du brasage ou du frittage du matériau d'interface thermique, la résistance thermique résultante est faible mais le procédé reste complexe à mettre en oeuvre et les contraintes mécaniques dans le joint réalisé sont très élevées, limitant ainsi sa fiabilité thermomécanique. Pour les joints brasés, ceci provient de la complexité de braser proprement avec un faible taux de pores (voids, en anglais) des substrats métallisés sur le radiateur à cause de leurs cambrures et des larges surfaces de contact. Pour le frittage, ceci provient de la nécessité d'appliquer des forces élevées et homogènes qui abattent les propriétés finales des joints. Dans le cas de l'utilisation de joints souples, comme la graisse thermique, le procédé est facile à mettre en oeuvre mais les matériaux ne sont pas compatibles avec les températures supérieures à 175°C et présentent des conductivités thermiques faibles (de l'ordre de 2W/mK).

Dans le cas du document US 8 432 030, le problème lié au matériau d'interface thermique est éliminé en utilisant un fluide de refroidissement en contact direct avec la face inférieure des substrats. Cependant, dans cette configuration, la surface d'échange est fortement réduite et la résistance thermique de convection est plus élevée.

US 2013/256894 A1 (ADEMA GRETCHEN [US]) 3 octobre 2013 (2013-10-03) décrit un procédé de fabrication d'un module électronique de puissance par fabrication additive.

### Présentation de l'invention

L'invention vise à remédier à ces inconvénients de manière simple, fiable et peu onéreuse.

A cet effet, l'invention concerne un procédé de fabrication d'un module électronique de puissance par fabrication additive, caractérisé en ce qu'il comporte les étapes consistant à :
- déposer en une seule étape, par électrodéposition, une couche d'un matériau nanoporeux électriquement conducteur directement sur un substrat comprenant une couche électriquement isolante et au moins une couche de matériau métallique conducteur, appelé substrat métallisé,
- disposer un élément, par exemple un composant actif de type composant de puissance à semi-conducteur, sur la couche de matériau nanoporeux et procéder au frittage de la couche de matériau nanoporeux, de façon à assurer une liaison mécanique et électrique entre ledit élément et le substrat métallisé.

Un matériau nanoporeux est un matériau présentant des pores dont les dimensions sont inférieures à 1 micron.

Les pores peuvent présenter des dimensions comprises entre 10 et 400 nm, par exemple.

L'opération de frittage permet d'assurer une liaison efficace et simple à mettre en oeuvre entre l'élément et le substrat métallisé.

La couche de matériau nanoporeux est réalisée en une seule étape par un procédé d'électrodéposition et est directement attachée physiquement au substrat métallisé, formant ainsi une unité solidaire.

La réalisation de la couche nano poreuse peut être obtenue par trempage dans un bain électrolytique, les zones concernées étant reliées à un potentiel électrique par l'intermédiaire d'une électrode. Le matériau nanoporeux peut être obtenu en une seule étape en ajoutant des additifs au bain électrolytique et/ou en utilisant des impulsions de courant, comme cela est connu en soi.

La couche de matériau nanoporeux a par exemple une épaisseur comprise entre 1 et 100 microns.

Le frittage peut être réalisé à une température comprise entre 200°C et 300°C, avec application d'une pression comprise entre 1 et 10 MPa. Ceci permet de réaliser une bonne attache sans impacter les propriétés des composants et les substrats à assembler. Afin d'éviter l'oxydation, il est possible de réaliser le frittage sous atmosphère inerte ou de réaliser un frittage rapide par laser.

Le procédé peut comporter les étapes consistant à :
- réaliser ou fixer des préformes en matériau polymère sur au moins une face du substrat métallisé,
- déposer une première couche métallique sur la préforme,
- déposer par électroformage une seconde couche métallique sur la première couche métallique.

Les préformes peuvent être réalisées par fabrication additive. Les préformes peuvent être réalisées ou fixées sur au moins deux faces opposées du substrat métallisé.

La seconde couche peut présenter une épaisseur comprise entre quelques microns et quelques millimètres, en fonction de besoins. Il est possible de faire varier l'épaisseur de la seconde couche en fonction la tension appliquée et du temps de polarisation appliqués lors de l'étape de déposition par électroformage.

Lors du dépôt par électroformage, tout ou partie du substrat métallique et de la première couche métallique est plongée dans un bain électrolytique comportant des ions métalliques, par exemple du cuivre sous forme ionique. Une électrode est reliée électriquement à la première couche métallique, un potentiel électrique étant appliqué à ladite électrode de façon à déposer le métal d'apport du bain électrolytique sur la première couche métallique. Les zones non métalliques du substrat qui ne sont pas au potentiel de l'électrode ne sont alors pas recouvertes de métal d'apport.

La couche de matériau nanoporeux peut être déposée sur la seconde couche métallique.

Le procédé peut comporter une étape de dissolution des préformes en matériau polymère par voie chimique ou par voie thermique.

Il est ainsi possible de réaliser des zones en creux, des connectiques ou des canaux dans le module électronique de puissance ainsi obtenu. Les canaux peuvent notamment permettre de faciliter les échanges thermiques en vue du refroidissement de l'ensemble, par exemple par l'intermédiaire d'un flux d'air ou d'un fluide de refroidissement liquide.

Le procédé peut comporter une étape de recouvrement d'au moins une zone de la couche conductrice du substrat métallisé à l'aide d'un film de protection en matériau non conducteur, avant dépôt de la première couche métallique et de la seconde couche métallique.

Le film de protection est par exemple réalisé en matériau polymère.

Le film de protection permet d'empêcher le dépôt de métal sur la zone recouverte du substrat métallisé.

Le film de protection peut être retiré lors de l'étape de dissolution des préformes.

Le procédé peut comporter une étape de suppression d'au moins une zone du film de protection de façon à former une ouverture, un picot étant obtenu par dépôt des premières et secondes couches métallique dans ladite ouverture.

Chaque picot peut permettre de réaliser la liaison électrique entre une piste formée dans la couche conductrice du substrat métallisé et un élément, tel par exemple qu'un composant de puissance à semi-conducteur ou une autre piste conductrice.

Le procédé selon l'invention peut comporter les étapes consistant à :
- déposer une couche d'un matériau nanoporeux électriquement conducteur sur un premier substrat comprenant une couche électriquement isolante et au moins une couche de matériau métallique conducteur, appelé premier substrat métallisé, de manière à former un premier ensemble,
- déposer une couche d'un matériau nanoporeux électriquement conducteur sur au moins un picot formé sur un second substrat comprenant une couche électriquement isolante et au moins une couche de matériau métallique conducteur, appelé second substrat métallisé, de manière à former un second ensemble,
- disposer au moins un élément, par exemple un composant de puissance à semi-conducteur, entre les couches de matériau nanoporeux des premier et second ensembles,
- procéder au frittage des couches de matériau nanoporeux des premier et second ensembles, de façon à assurer une liaison mécanique et électrique entre ledit élément et les substrats métallisés des premiers et second ensembles.

Les couches de matériau nanoporeux peuvent être frittées lors d'opération de frittage séparées les unes des autres. En variante, les couches de matériau nanoporeux peuvent être frittées simultanément.

Au moins un picot peut relier le substrat métallisé du premier ensemble, en particulier une piste dudit substrat, et le substrat métallisé du second ensemble, en particulier une piste dudit substrat, par l'intermédiaire d'une couche de matériau nanoporeux fritté.

Le substrat peut comporter au moins une couche isolante en céramique.

La ou les couches métalliques du substrat métallisé peuvent être assemblée à la couche isolante par brasage (ou en terminologie anglo-saxonne « Active Metal Brazing » ou « AMB), par liaison directe de cuivre (ou en terminologie anglo-saxonne « Direct Bonded Copper » ou « DBC »), ou encore par liaison directe d'aluminium (ou en terminologie anglo-saxonne « Direct Bonded Aluminium » ou encore « DBA »).

La couche isolante peut également être une couche de polymère.

La première couche métallique peut avoir une épaisseur inférieure à 5 microns, de préférence inférieure à 1 microns.

La première couche métallique peut être déposée sur la préforme par réduction chimique via aspersion.

Le module électronique de puissance peut comporter un boîtier dans lequel sont logés le substrat métallisé et le composant actif, le procédé comportant une étape de remplissage du boîtier, au moins en partie, à l'aide d'un matériau isolant.

Le matériau isolant est par exemple un gel à base de silicone ou de résine époxy.

L'invention concerne également un module électronique de puissance obtenu par le procédé précité, comportant un substrat métallisé et un composant actif monté sur une première face du substrat métallisé, par l'intermédiaire d'une couche de matériau nanoporeux fritté, un dissipateur thermique comportant des canaux de refroidissement s'étendant depuis une seconde face du substrat métallisé, opposée à la première face.

Le module électronique de puissance peut comporter au moins une connectique reliée électriquement au substrat métallisé.

La connectique peut être formée par un organe conducteur s'étendant depuis la première face du substrat métallisé.

Le module électronique de puissance peut comporter un premier ensemble comportant un premier substrat métallisé et un second ensemble comportant un second substrat métallisé. Une première couche métallique du premier substrat métallisé peut comporter des pistes isolées électriquement les unes des autres.

Une première couche métallique du second substrat métallisé peut comporter des pistes isolées électriquement les unes des autres.

Un dissipateur thermique comportant des canaux peut s'étendre depuis une seconde couche métallique du premier substrat métallisé, opposée à la première couche métallique.

Un dissipateur thermique comportant des canaux peut s'étendre depuis une seconde couche métallique du second substrat métallisé, opposée à la première couche métallique.

Des picots peuvent s'étendre depuis au moins une piste de la première couche métallique du second substrat métallisé.

Une première face du composant actif peut être reliée électriquement à au moins une piste du premier substrat métallisé par l'intermédiaire d'une couche de matériau nanoporeux fritté.

Une seconde face du composant actif peut être reliée électriquement à au moins une piste du second substrat métallisé par l'intermédiaire d'au moins un premier picot et d'une couche de matériau nanoporeux fritté située entre le picot et la seconde face du composant actif.

Une piste du premier substrat métallisé peut être reliée à une piste du second substrat métallisé, par l'intermédiaire d'au moins un second picot et d'une couche de matériau nanoporeux fritté située entre le picot et la piste du premier substrat métallisé.

L'invention concerne également un aéronef comportant au moins un module électronique de puissance du type précité.

### Brève description des figures

[Fig. 1] est une vue schématique illustrant un module électronique de puissance de l'art antérieur,
[Fig. 2],
[Fig. 3],
[Fig. 4],
[Fig. 5],
[Fig. 6],
[Fig. 7],
[Fig. 8] et
[Fig. 9] illustrent différentes étapes d'un procédé de fabrication d'un module électronique de puissance selon une forme de réalisation de l'invention.

### Description détaillée de l'invention

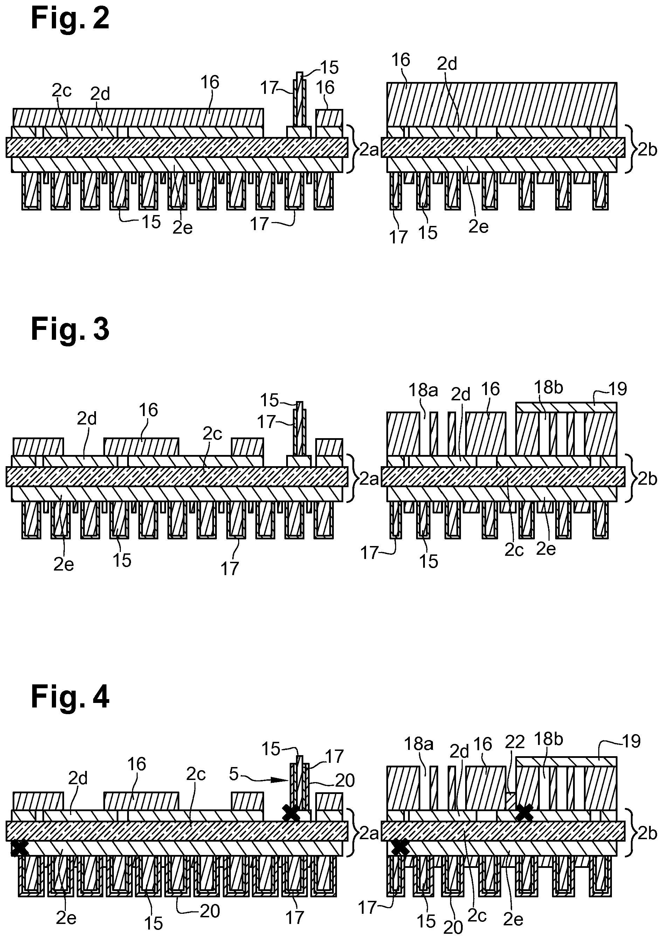

Les figures 2 à 6 illustrent schématiquement les différentes étapes de fabrication d'un module électronique de puissance 1 selon une forme de réalisation de l'invention.

Dans une première étape illustrée à la figure 2, des préformes 15 en matériau polymère sont réalisées par fabrication additive sur deux faces opposées d'un premier substrat métallisé 2a et d'un second substrat métallisé 2b. Les préformes 15 peuvent être réalisées directement sur chaque substrat métallisé 2a, 2b ou être attachées audit substrat métallisé 2a, 2b après réalisation des préformes 15. Dans ce dernier cas, les préformes 15 peuvent être collées au substrat métallisé 2a, 2b correspondant.

Chaque substrat métallisé 2a, 2b comporte une couche électriquement isolante 2c en matériau céramique revêtue sur chacune de ses faces opposées d'une couche métallique 2d, 2e, par exemple en cuivre. Les couches métalliques 2d, 2e du substrat métallisé 2a, 2b peuvent être assemblées à la couche isolante 2c par brasage (ou en terminologie anglo-saxonne « Active Metal Brazing » ou « AMB), par liaison directe de cuivre (ou en terminologie anglo-saxonne « Direct Bonded Copper » ou « DBC »), ou encore par liaison directe d'aluminium (ou en terminologie anglo-saxonne « Direct Bonded Aluminium » ou encore « DBA »).

En variante, la couche électriquement isolante 2c peut être réalisée en matériau polymère (dans le cas d'un substrat de type IMS ou Insulated Metal Substrate, en anglais).

Les couches métalliques 2d forment des pistes électriquement distinctes les unes des autres. Des films de protection 16 en matériau polymère recouvrent au moins une partie des pistes conductrices de la couche supérieure 2d.

Comme illustré à la figure 2, une première couche métallique 17, par exemple en argent ou cuivre, est déposée sur les préformes 15, par exemple par réduction chimique via aspersion. La première couche 17 présente une épaisseur inférieure à 1 microns par exemple. D'autres techniques de de dépôt peuvent être utilisées, telles par exemple que le revêtement par pulverisation ou projection (« spray coating », en anglais), ou l'enduction par trempage (« dip coating », en anglais).

Certaines des préformes 15 peuvent être pré-métallisées, c'est-à-dire revêtues de la première couche métallique 17 avant assemblage sur le substrat métallisé 2a, 2b correspondant.

Des ouvertures 18a, 18b sont formées dans le film protecteur 16 recouvrant le second substrat 2b, certaines de ces ouvertures (à savoir les ouvertures 18b) étant recouvertes d'un film de protection annexe 19.

Une seconde couche métallique 20, par exemple en cuivre, est ensuite déposée sur la première couche métallique 17, comme illustré à la figure 4. Un tel dépôt est réalisé par électroformage.

La seconde couche 20 présente une épaisseur comprise entre quelques microns et quelques millimètres, en fonction des besoins. Il est possible de faire varier l'épaisseur de la seconde couche 20 en fonction la tension appliquée et du temps de polarisation appliqués lors de l'étape de déposition par électroformage.

Lors du dépôt par électroformage, tout ou partie du substrat métallisé 2a, 2b et de la première couche métallique 17 est plongée dans un bain électrolytique comportant des ions métalliques, par exemples du cuivre sous forme ionique. Le bain peut être un bain à basse température, c'est-à-dire à une température inférieure à 100°C. Une électrode est reliée électriquement à certaines des pistes conductrices des couches 2d des substrats 2a, 2b et aux couches métalliques 2e des substrats 2a, 2b. Les pistes ou les couches conductrices reliées à l'électrode sont schématisées à l'aide de croix sur la figure 4 notamment. Un potentiel électrique est appliqué à ces zones, par l'intermédiaire de ladite électrode, de façon à déposer le métal d'apport du bain électrolytique sur la première couche métallique 17. Les zones non métalliques du substrat 2a, 2b, les zones recouvertes du film de protection 16 ou les zones métalliques qui ne sont pas au potentiel de l'électrode, ne sont alors pas recouvertes de métal d'apport.

La seconde couche métallique 17 peut notamment délimiter des connectiques 5, des parties de boîtier, des canaux de refroidissement 21 de dissipateurs thermiques ou radiateurs 11 et des picots 22.

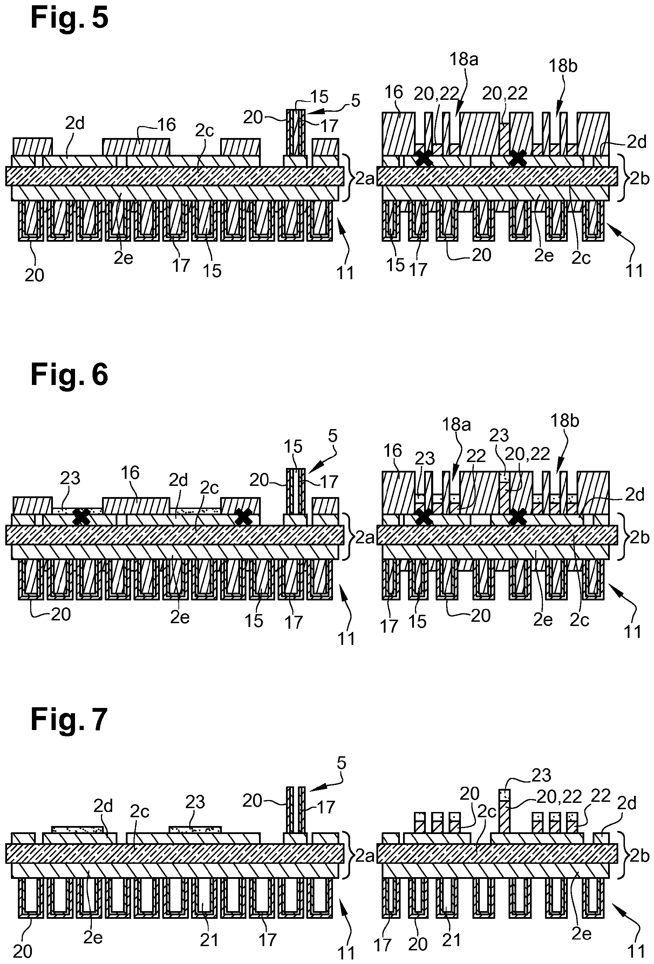

Le dépôt de la seconde couche 20 peut être réalisées au plusieurs étapes, comme illustré aux figures 4 et 5. Dans une première étape illustrée à la figure 4, les ouvertures 18b sont recouvertes par le film de protection auxiliaire 19, de sorte que seules la ou les ouvertures 18a dont la ou les pistes conductrices correspondantes sont au potentiel électrique souhaité sont progressivement remplies de métal d'apport 20. Dans une seconde étape illustrée à la figure 5, le film de protection auxiliaire 19 est retiré, découvrant les ouvertures18b, de sorte que du métal d'apport puisse également être déposé dans ces ouvertures 18b, pour autant que les pistes conductrices correspondantes soient au potentiel électrique souhaité. De cette manière, il est possible de réaliser des picot 22 de longueurs différentes, en fonction des pistes reliées à l'électrode et/ou en fonction des ouvertures 18a, 18b recouvertes par le film auxiliaire 19.

Une couche de matériau nanoporeux électriquement conducteur 23 est ensuite déposée sur certaines pistes des couches métalliques 2d des premier et second substrats métallisés 2a, 2b, comme illustré à la figure 6.

La couche de matériau nanoporeux 23 a par exemple une épaisseur comprise entre 1 et 100 microns. Le matériau nanoporeux présente des pores dont les dimensions sont inférieures à 1 micron.

La réalisation de la couche nanoporeuse 23 est obtenue par trempage dans un bain électrolytique, les pistes concernées étant reliées à un potentiel par l'intermédiaire d'une électrode, comme illustré schématiquement par des croix à la figure 6. Le matériau nanoporeux est obtenu en une seule étape en ajoutant des additifs au bain électrolytique et/ou en utilisant des impulsions de courant, comme cela est connu en soi.

Comme illustré à la figure 7, les préformes 15 sont ensuite retirées lors d'une étape de dissolution par voie chimique ou par voie thermique.

Dans le cas d'une dissolution par voie chimique, il est possible de réaliser la dissolution de préformes 15 en ABS à l'aide d'un bain d'acétone, à une température de 50°C et avec utilisation d'ultrasons.

En variante, pour réaliser la dissolution de préformes 15 en PLA, il est possible d'utiliser un bain de soude à 35%, à une température de 60°C, et de procéder à une agitation afin de favoriser la dissolution.

Il est ainsi possible de réaliser des zones en creux, les connectiques 5 ou les canaux 21 destinés à permettre de faciliter les échanges thermiques en vue du refroidissement de l'ensemble, par exemple par l'intermédiaire d'un flux d'air ou d'un fluide de refroidissement liquide.

Les films de protection 16 peuvent être également retirés lors de l'étape de dissolution.

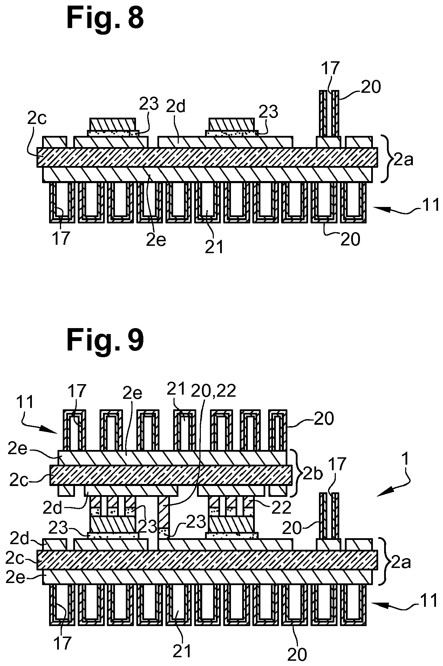

Des composants actifs de type composants de puissance à semi-conducteurs 3 sont déposés sur la couche de matériau nanoporeux 23 déposée sur le premier substrat métallisé 2a (figure 8). Ladite couche de matériau nanoporeux 23 est ensuite frittée de façon à assurer une liaison mécanique et électrique entre une première face desdits composants 3 et le premier substrat métallisé 2a.

Le second substrat métallisé 2b est ensuite placé en regard du premier substrat métallisé de façon à ce que la couche de matériau nanoporeux 23 déposée sur les extrémités des picots 22 soient en contact avec la seconde face desdites composants 3 et avec l'une des pistes du premier substrat métallisé 2a, respectivement (figure 9). Ladite couche de matériau nanoporeux 23 est ensuite frittée de façon à assurer une liaison mécanique et électrique entre les picots 22, la seconde face desdits composants 3 et la piste correspondante du premier substrat métallisé 2a.

Le frittage est réalisé à une température comprise entre 200°C et 300°C, avec application d'une pression comprise entre 1 et 10 MPa, dans le cas d'une couche de cuivre nanoporeux. Ceci permet de réaliser une bonne attache mécanique sans impacter les propriétés des composants 3 et les substrats 2a, 2b à assembler. Afin d'éviter l'oxydation, il est possible de réaliser le frittage sous atmosphère inerte ou de réaliser un frittage rapide par laser.

Une seule opération de frittage simultanée de l'ensemble des couches de matériau nanoporeux 23 peut être envisagée.

Un boîtier rattaché aux substrats 2a, 2b est ensuite rempli par un encapsulant ou isolant électrique, tel qu'un gel ou époxy, pour assurer une protection mécanique et électrique des composants de puissance 3.

Un tel procédé présente notamment les avantages suivants :
- réalisation d'une structure quasiment finie par un procédé aisément industrialisable,
- attache des composants de puissance 3 avec des électrodes de petites tailles sans risque de court-circuit à l'aide du frittage,
- bonne performance thermique, due notamment à la réduction des interfaces entre les composants de puissance 3 et les dissipateurs thermiques 11 et au fait de pouvoir réaliser des dissipateurs thermiques 11 pouvant présenter des formes géométriques complexes,
- possibilité d'utilisation du module de puissance 1 à très haute température grâce notamment à l'élimination des matériaux d'interface thermique dont l'utilisation est limitée en température, ou encore grâce à l'absence de brasure,
- amélioration de la fiabilité du fait de l'absence de brasure,
- augmentation de la densité de puissance massique des convertisseurs grâce à la réduction des masses des dissipateurs thermiques 11,
- réduction des contraintes résiduelles comparées à la même réalisation par les techniques de fabrication additive nécessitant des températures locales très élevées pour la fusion ou le frittage de poudres métalliques,
- étanchéité des canaux 21 des dissipateurs thermiques 11 grâce à l'absence de porosité et de lacune dans le matériau 20 électro-déposé.

## Revendications

1. Procédé de fabrication d'un module électronique de puissance (1) par fabrication additive, comportant les étapes consistant à :
- déposer en une seule étape, par électrodéposition une couche d'un matériau nanoporeux électriquement conducteur (23) directement sur un substrat (2a, 2b) comprenant une couche électriquement isolante (2c) et au moins une couche de matériau métallique conducteur (2d, 2e), appelé substrat métallisé (2a, 2b),
- disposer un élément, par exemple un composant actif de type composant de puissance à semi-conducteur (3), sur la couche de matériau nanoporeux (23) et procéder au frittage de la couche de matériau nanoporeux (23), de façon à assurer une liaison mécanique et électrique entre ledit élément (3) et le substrat métallisé (2a, 2b),
**caractérisé en ce qu'**il comporte les étapes consistant à :
- réaliser ou fixer des préformes (15) en matériau polymère sur au moins une face du substrat métallisé (2a, 2b),
- déposer une première couche métallique (17) sur la préforme (15),
- déposer par électroformage une seconde couche métallique (20) sur la première couche métallique (17).

2. Procédé selon la revendication 1, **caractérisé en ce que** la couche de matériau nanoporeux (23) est déposée sur la seconde couche métallique (20).

3. Procédé selon la revendication 1 ou 2, **caractérisé en ce qu'**il comporte une étape de dissolution des préformes (15) en matériau polymère par voie chimique ou par voie thermique.

4. Procédé selon la revendication 1 ou 2, **caractérisé en ce qu'**il comporte une étape de recouvrement d'au moins une zone de la couche conductrice (2d) du substrat métallisé (2a, 2b) à l'aide d'un film de protection (16) en matériau non conducteur, avant dépôt de la première couche métallique (17) et de la seconde couche métallique (20).

5. Procédé selon la revendication 4, **caractérisé en ce qu'**il comporte une étape de réalisation de suppression d'au moins une zone du film de protection (16) de façon à former une ouverture (18a, 18b), un picot (22) étant obtenu par dépôt des première et secondes couches métallique (17, 20) dans ladite ouverture (18a, 18b).

6. Procédé selon l'une des revendications 1 à 5, **caractérisé en ce que** le substrat (2a, 2b) comporte au moins une couche isolante (2c) en céramique.

7. Procédé selon l'une des revendications 1 à 6, **caractérisé en ce que** la première couche métallique (17) a une épaisseur inférieure à 5 microns, de préférence inférieure à 1 microns.

8. Procédé selon les revendications 1 et 7, **caractérisé en ce que** le module électronique de puissance (1) comporte un boîtier dans lequel sont logés le substrat métallisé (2a, 2b) et le composant actif (3), le procédé comportant une étape de remplissage du boîtier, au moins en partie, à l'aide d'un matériau isolant.

## Patentansprüche

1. Verfahren zur Herstellung eines elektronischen Leistungsmoduls (1) durch additive Fertigung, umfassend die folgenden Schritte:
- Abscheiden einer Schicht aus einem elektrisch leitenden nanoporösen Material (23) in einem einzigen Schritt durch Elektroabscheidung direkt auf einem Substrat (2a, 2b) mit einer elektrisch isolierenden Schicht (2c) und zumindest einer Schicht aus einem leitenden metallischen Material (2d, 2e), metallisiertes Substrat (2a, 2b) genannt,
- Anordnen eines Elements, beispielsweise eines aktiven Bauteils vom Typ Halbleiter-Leistungsbauteil (3), auf der Schicht aus nanoporösem Material (23) und Sintern der Schicht aus nanoporösem Material (23), so dass eine mechanische und elektrische Verbindung zwischen dem Element (3) und dem metallisierten Substrat (2a, 2b) sichergestellt wird,
**dadurch gekennzeichnet, dass** es die folgenden Schritte umfasst:
- Herstellen oder Befestigen von Vorformlingen (15) aus Polymermaterial auf zumindest einer Seite des metallisierten Substrats (2a, 2b),
- Abscheiden einer ersten Metallschicht (17) auf dem Vorformling (15),
- Abscheiden einer zweiten Metallschicht (20) durch Galvanoformung auf der ersten Metallschicht (17).

2. Verfahren nach Anspruch 1,
**dadurch gekennzeichnet, dass** die Schicht aus nanoporösem Material (23) auf der zweiten Metallschicht (20) abgeschieden wird.

3. Verfahren nach Anspruch 1 oder 2,
**dadurch gekennzeichnet, dass** es einen Schritt des Auflösens der Vorformlinge (15) aus Polymermaterial auf chemischem oder thermischem Weg umfasst.

4. Verfahren nach Anspruch 1 oder 2,
**dadurch gekennzeichnet, dass** es vor dem Abscheiden der ersten Metallschicht (17) und der zweiten Metallschicht (20) einen Schritt des Abdeckens von zumindest einem Bereich der leitenden Schicht (2d) des metallisierten Substrats (2a, 2b) mit Hilfe eines Schutzfilms (16) aus nichtleitendem Material umfasst.

5. Verfahren nach Anspruch 4,
**dadurch gekennzeichnet, dass** es einen Schritt des Entfernens von zumindest einem Bereich des Schutzfilms (16) umfasst, so dass eine Öffnung (18a, 18b) gebildet wird, wobei ein Zapfen (22) durch Abscheidung der ersten und der zweiten Metallschicht (17, 20) in der Öffnung (18a, 18b) erhalten wird.

6. Verfahren nach einem der Ansprüche 1 bis 5,
**dadurch gekennzeichnet, dass** das Substrat (2a, 2b) zumindest eine Isolierschicht (2c) aus Keramik aufweist.

7. Verfahren nach einem der Ansprüche 1 bis 6,
**dadurch gekennzeichnet, dass** die erste Metallschicht (17) eine Dicke von weniger als 5 Mikrometer, vorzugsweise weniger als 1 Mikrometer, aufweist.

8. Verfahren nach Anspruch 1 und 7,
**dadurch gekennzeichnet, dass** das elektronische Leistungsmodul (1) ein Gehäuse umfasst, in dem das metallisierte Substrat (2a, 2b) und das aktive Bauteil (3) aufgenommen sind, wobei das Verfahren einen Schritt umfasst, bei dem das Gehäuse zumindest teilweise mit einem Isoliermaterial gefüllt wird.

## Claims

1. A method of manufacturing a power electronic module (1) by additive manufacturing, comprising the steps of:
- depositing in a single step, by electrodeposition, a layer of electrically conductive nanoporous material (23) directly on a substrate (2a, 2b) comprising an electrically insulating layer (2c) and at least one layer of conductive metal material (2d, 2e), called a metallized substrate (2a, 2b)
- placing an element, for example an active component of the semiconductor power component type (3), on the layer of nanoporous material (23) and sintering the layer of nanoporous material (23), so as to ensure a mechanical and electrical connection between said element (3) and the metallized substrate (2a, 2b),
**characterized in that** it comprises the steps of:
- making or fixing preforms (15) of polymer material on at least one face of the metallized substrate (2a, 2b),
- depositing a first metal layer (17) on the preform (15),
- depositing a second metal layer (20) on the first metal layer (17) by electroforming.

2. A method according to claim 1, **characterized in that** the layer of nanoporous material (23) is deposited on the second metal layer (20).

3. A method according to claim 1 or 2, **characterized in that** it comprises a step of dissolving the preforms (15) of polymeric material by chemical or thermal means.

4. A method according to claim 1 or 2, **characterized in that** it comprises a step of covering at least one area of the conductive layer (2d) of the metallized substrate (2a, 2b) with a protective film (16) made of non-conductive material, before deposition of the first metal layer (17) and of the second metal layer (20).

5. A method according to claim 4, **characterized in that** it comprises a step of carrying out the removal of at least one zone of the protective film (16) so as to form an opening (18a, 18b), a spike (22) being obtained by depositing the first and second metal layers (17, 20) in the said opening (18a, 18b).

6. A method for one of the claims 1 to 5, **characterized in that** the substrate (2a, 2b) comprises at least one insulating layer (2c) of ceramic.

7. A method according to any of claims 1 to 6, **characterized in that** the first metal layer (17) has a thickness of less than 5 microns, preferably less than 1 micron.

8. A method according to claims 1 and 7, **characterized in that** the power electronic module (1) comprises a housing in which the metallized substrate (2a, 2b) and the active component (3) are housed, the method comprising a step of filling the housing, at least in part, with an insulating material.
